# FASCICULE DE BREVET EUROPEEN

(11) **EP 3 024 030 B1**
(45) Date de publication et mention de la délivrance du brevet: **05.07.2017**
(21) Numéro de dépôt: 15194809.8
(22) Date de dépôt: 16.11.2015
(51) Int. Cl.: H01L 27/15, H01L 33/50, G09F 9/33, H01L 25/16, H01L 33/00, H01L 33/60, H01L 33/62

(54) **DISPOSITIF OPTOÉLECTRONIQUE À DIODES ÉLECTROLUMINESCENTES ET SON PROCÉDÉ DE FABRICATION**
OPTOELEKTRONISCHE VORRICHTUNG MIT LEUCHTDIODEN UND HERSTELLUNGSVERFAHREN DAFÜR
OPTOELECTRONIC DEVICE WITH LIGHT EMITTING DIODES AND METHOD OF MANUFACTURING THE SAME

(30) Priorité: 18.11.2014 FR 1461099
(43) Date de publication de la demande: 25.05.2016
(73) Titulaire: COMMISSARIAT À L'ÉNERGIE ATOMIQUE ET AUX ÉNERGIES ALTERNATIVES, 75015 Paris (FR); ALCATEL LUCENT, 92100 Boulogne-Billancourt (FR)
(72) Inventeur: Robin, Ivan-Christophe, 38000 GRENOBLE (FR); Bono, Hubert, 38000 GRENOBLE (FR); Fargeix, Alain, 38100 GRENOBLE (FR); Izquierdo, Ricardo, Montréal, Québec H4XIK9 (CA); Le Calvez, Stéphanie, 38360 SASSENAGE (FR); Sanchot, Audrey, 38000 GRENOBLE (FR)
(74) Mandataire: Thibon, Laurent

(56) Documents cités:
- EP-A2- 2 500 626
- WO-A1-2014/030830
- US-A1- 2004 145 629
- US-A1- 2009 213 296
- US-A1- 2011 175 117
- US-A1- 2011 294 240
- US-A1- 2011 297 975
- US-B1- 6 207 229

## Description

### Domaine

La présente invention concerne un dispositif optoélectronique, notamment un écran d'affichage ou un dispositif de projection d'images, à diodes électroluminescentes à base de matériaux semiconducteurs et un procédé de fabrication correspondant.

### Exposé de l'art antérieur

Il existe des dispositifs optoélectroniques comprenant des diodes électroluminescentes à base de matériaux semiconducteurs comprenant un empilement de couches semiconductrices comportant majoritairement au moins un élément du groupe III et un élément du groupe V, appelé par la suite composé III-V, notamment le nitrure de gallium (GaN), le nitrure de gallium et d'indium (GaInN) et le nitrure de gallium et d'aluminium (GaAlN).

Les diodes électroluminescentes à base de GaN disponibles actuellement dans le commerce sont adaptées à l'émission d'un rayonnement ultraviolet ou d'une lumière bleue. Il est connu que l'augmentation de la proportion d'indium dans du GaInN permet d'augmenter la longueur d'onde du rayonnement émis. Toutefois, lorsque la proportion d'indium s'élève au-delà de 20 % en masse, le rendement quantique de la diode électroluminescente diminue fortement.

Il est connu de recouvrir une diode électroluminescente d'une couche de matériaux photoluminescents pour convertir au moins une partie du rayonnement émis par la diode électroluminescente en un rayonnement à une autre longueur d'onde. Un exemple de matériau photoluminescent est le grenat d'yttrium et d'aluminium (YAG, sigle anglais pour Yttrium Aluminium Garnet) activé par l'ion cérium trivalent, également appelé YAG:Ce ou YAG:Ce³⁺. La taille moyenne des particules des matériaux photoluminescents classiques est généralement supérieure à 5 µm.

Un dispositif optoélectronique, tel qu'un écran d'affichage ou un dispositif de projection, à base de diodes électroluminescentes peut comprendre une matrice de pixels d'affichage émettant de la lumière rouge, verte ou bleue, chaque pixel d'affichage comprenant au moins une diode électroluminescente. Pour obtenir des pixels d'affichage émettant de la lumière rouge ou verte, une possibilité est de prévoir une matrice de diodes électroluminescentes émettant de la lumière bleue et de recouvrir certaines de ces diodes électroluminescentes par un matériau photoluminescent adapté à convertir la lumière bleue en lumière rouge ou verte.

Il y a une tendance à la réduction des dimensions des pixels d'affichage, notamment pour augmenter la résolution des écrans d'affichage ou des dispositifs de projection. Les dimensions latérales des diodes électroluminescentes peuvent alors être inférieures à 30 µm. Toutefois, l'épaisseur du matériau photoluminescent, tel que le YAG:Ce³⁺, doit être supérieure à plusieurs centaines de micromètres pour convertir la totalité du rayonnement lumineux fourni par une diode électroluminescente. Un inconvénient est que l'utilisation de ces matériaux photoluminescents n'est pas compatible avec la réalisation de diodes électroluminescentes de faibles dimensions latérales.

Les documents US 2011/297975 A1, EP 2 500 626 A2, WO 2014/030830 A1 et US 2011/175117 A1 décrivent des dispositifs optoélectroniques, avantageusement arrangés en réseaux émetteurs de lumière, comprenant des diodes électroluminescentes recouvertes de matériaux photoluminescents. Le document US 6 207 229 B1 décrit, quant à lui, les propriétés photoluminescentes de nanocristaux coeur-coquille en semiconducteurs Cd(S,Se,Te)-Zn(S,Se).

### Résumé

Un objet d'un mode de réalisation vise à pallier tout ou partie des inconvénients des dispositifs optoélectroniques à diodes électroluminescentes décrits précédemment.

Un autre objet d'un mode de réalisation est que les diodes électroluminescentes comprennent un empilement de couches semiconductrices comportant majoritairement un composé III-V.

Un autre objet d'un mode de réalisation est que les dimensions latérales des diodes électroluminescentes sont inférieures à 30 µm.

Un autre objet d'un mode de réalisation est que le dispositif optoélectronique comprend une matrice de pixels d'affichage émettant chacun de la lumière verte, rouge ou bleue.

Ainsi, la présente invention prévoit, d'après un mode de réalisation selon la revendication indépendante 4, un dispositif optoélectronique comprenant une matrice de diodes électroluminescentes et des blocs photoluminescents en vis-à-vis d'au moins une partie des diodes électroluminescentes, chaque diode électroluminescente ayant une dimension latérale inférieure à 30 µm, chaque bloc photoluminescent comprenant des cristaux semiconducteurs, dont la taille moyenne est inférieure à 1 µm, dispersés dans une matrice liante, le dispositif optoélectronique comprenant, en outre, un circuit électronique comprenant les diodes électroluminescentes, et un substrat fixé au circuit électronique, les blocs photoluminescents étant localisés dans des ouvertures du substrat, le substrat étant aminci pour exposer les blocs photoluminescents. Selon un mode de réalisation, chaque bloc photoluminescent a une épaisseur inférieure à 50 µm, de préférence inférieure à 5 µm.

Selon un mode de réalisation, la taille moyenne des cristaux semiconducteurs est inférieure à 500 nm, de préférence inférieure à 50 nm.

Selon un mode de réalisation, les cristaux semiconducteurs sont au moins en un matériau choisi dans le groupe comprenant le séléniure de cadmium, le phosphure d'indium, le sulfure de cadmium, le sulfure de zinc, le séléniure de zinc, le tellurure de cadmium, le tellurure de zinc, l'oxyde de cadmium, l'oxyde de zinc et de cadmium, le sulfure de zinc et de cadmium, le séléniure de zinc et de cadmium, le sulfure d'argent et d'indium, et un mélange d'au moins deux de ces composés.

Selon un mode de réalisation, la matrice liante est en un polymère au moins en partie transparent.

Selon un mode de réalisation, chaque diode électroluminescente comprend un empilement de portions semiconductrices.

Selon un mode de réalisation, le dispositif comprend une grille, résultant dudit substrat aminci, grille délimitant les ouvertures situées en vis-à-vis des diodes électroluminescentes, les blocs photoluminescents étant disposés dans certaines desdites ouvertures.

Selon un mode de réalisation, chaque bloc photoluminescent est entouré latéralement par un revêtement réfléchissant.

Selon un mode de réalisation, le dispositif comprend un circuit électronique supplémentaire fixé au circuit électronique comprenant les diodes électroluminescentes par collage direct et relié électriquement aux diodes électroluminescentes. La présente invention prévoit également, d'après un mode de réalisation selon la revendication indépendante 1, un procédé de fabrication d'un dispositif optoélectronique comprenant les étapes suivantes :
(a) formation d'une matrice de diodes électroluminescentes, chaque diode électroluminescente ayant une dimension latérale inférieure à 30 µm ; et
(b) formation de blocs photoluminescents en vis-à-vis d'au moins une partie des diodes électroluminescentes, chaque bloc photoluminescent comprenant des cristaux semiconducteurs, dont la taille moyenne est inférieure à 1 µm, dispersés dans une matrice liante,
procédé dans lequel l'étape (a) comprend la fabrication d'un circuit optoélectronique comprenant les diodes électroluminescentes et dans lequel l'étape (b) comprend la formation d'ouvertures non traversantes dans un substrat, la formation des blocs photoluminescents dans certaines des ouvertures, la fixation du substrat au circuit optoélectronique et l'amincissement du substrat pour exposer les blocs photoluminescents. Selon un mode de réalisation, chaque bloc photoluminescent a une épaisseur inférieure à 30 µm, de préférence inférieure à 5 µm.

Selon un mode de réalisation, l'étape (b) comprend la formation des blocs photoluminescents par un procédé additif dans lesdites certaines des ouvertures. Selon un mode de réalisation, l'étape (b) comprend la formation des blocs photoluminescents par impression tridimensionnelle sur le circuit optoélectronique.

### Brève description des dessins

Ces caractéristiques et avantages, ainsi que d'autres, seront exposés en détail dans la description suivante d'un exemple illustratif puis de modes de réalisation particuliers faite à titre non limitatif en relation avec les figures jointes parmi lesquelles :
les figures 1 et 2 sont des vues avec coupe, partielles et schématiques, d'un exemple illustratif et d'un mode de réalisation d'un dispositif optoélectronique suivant la présente invention respectivement;
les figures 3A à 3J sont des vues avec coupe, partielles et schématiques, de structures obtenues à des étapes successives d'un mode de réalisation d'un procédé de fabrication du dispositif optoélectronique illustratif représenté en figure 1;
les figures 4A et 4B sont des vues avec coupe, partielles et schématiques, de structures obtenues à des étapes d'un mode de réalisation d'un procédé de fabrication du dispositif optoélectronique selon la présente invention représenté en figure 2; et
la figure 5 est une vue avec coupe, partielle et schématique, de la structure obtenue à une étape d'un autre mode de réalisation d'un procédé de fabrication du dispositif optoélectronique illustratif représenté en figure 1.

### Description détaillée

Par souci de clarté, de mêmes éléments ont été désignés par de mêmes références aux différentes figures et, de plus, comme cela est habituel dans la représentation des circuits intégrés, les diverses figures ne sont pas tracées à l'échelle. En outre, dans la suite de la description, les expressions "sensiblement", "environ" et "approximativement" signifient "à 10 % près". En outre, seuls les éléments utiles à la compréhension de la présente description ont été représentés et sont décrits. En particulier, les moyens de polarisation d'une diode électroluminescente d'un dispositif optoélectronique sont bien connus et ne sont pas décrits.

Dans la suite de la description, on appelle "zone active" d'une diode électroluminescente la région de la diode électroluminescente depuis laquelle est émise la majorité du rayonnement électromagnétique fourni par la diode électroluminescente. En outre, le terme "particule" tel qu'utilisé dans le cadre de la présente demande doit être compris dans un sens large et correspond non seulement à des particules compactes ayant plus ou moins une forme sphérique mais aussi à des particules anguleuses, des particules aplaties, des particules en forme de flocons, des particules en forme de fibres, ou des particules fibreuses, etc. On comprendra que la "taille" des particules dans le cadre de la présente demande signifie la plus petite dimension transversale des particules. On entend par particules d'un matériau les particules prises individuellement, c'est-à-dire les éléments unitaires du matériau, sachant que le matériau peut se présenter sous la forme d'agglomérats de particules. Par l'expression "taille moyenne" de particules, on entend selon la présente demande la moyenne arithmétique des tailles des particules, c'est-à-dire la somme des tailles des particules divisée par le nombre de particules. La granulométrie des particules peut être mesurée par granulométrie laser en utilisant, par exemple, un Malvern Mastersizer 2000.

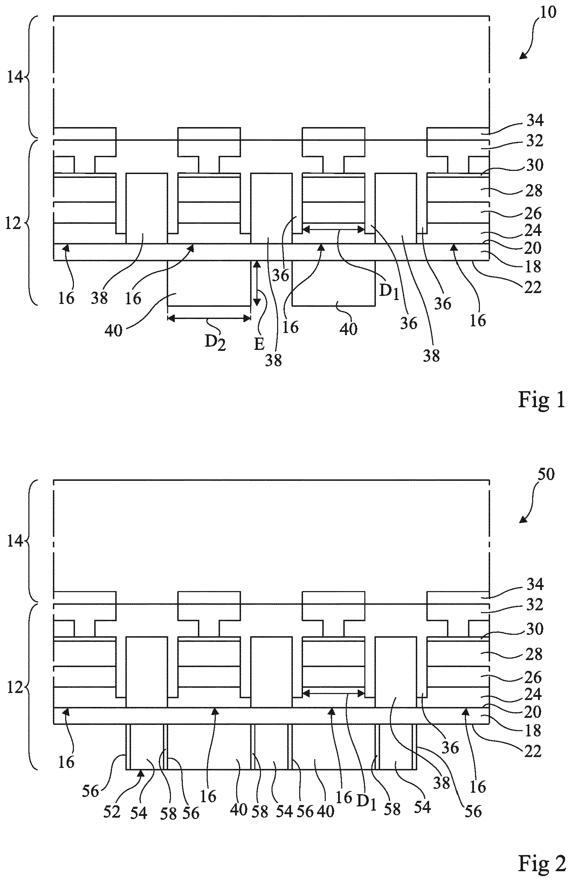

La figure 1 représente un exemple illustratif d'un dispositif optoélectronique 10 ne définissant pas, à lui seul, la présente invention, dispositif correspondant, par exemple, à un écran d'affichage ou à un dispositif de projection d'images.

Le dispositif 10 comprend deux circuits intégrés 12, 14. Le premier circuit intégré 12 comprend des diodes électroluminescentes 16 et est appelé circuit optoélectronique ou puce optoélectronique dans la suite de la description. Le deuxième circuit intégré 14 comprend des composants électroniques, non représentés, notamment des transistors, utilisés pour la commande des diodes électroluminescentes 16 du premier circuit intégré 12. Le deuxième circuit intégré 14 est appelé circuit de commande ou puce de commande dans la suite de la description. Le circuit optoélectronique 12 est fixé au circuit de commande 14. Selon le type de fixation, des inserts peuvent être éventuellement présents entre la puce optoélectronique 12 et la puce de commande 14.

Selon un mode de réalisation, chaque diode électroluminescente 16 comprend un empilement de couches semiconductrices contenant chacune majoritairement au moins un composé III-V. Selon un premier exemple, les diodes électroluminescentes 16 ont la structure décrite dans la demande de brevet FR14/50077 dans laquelle les diodes électroluminescentes 16 sont à cathode commune. Selon un deuxième exemple, les diodes électroluminescentes 16 ont la structure décrite dans la publication intitulée "III-nitride micro-emitter arrays: development and applications" aux noms de Z.Y. Fan, J.Y. Lin, et H.X. Jiang (Journal of Physics D: Applied Physics, volume 41, numéro 9, 094001, 12 pages, 2008).

Selon un mode de réalisation, le circuit optoélectronique 12 comprend une couche 18 semiconductrice comprenant des faces 20 et 22 opposées et parallèles. Les diodes électroluminescentes 16 reposent sur la face 20 de la couche 18. La couche 18 est par exemple une couche semiconductrice fortement dopée d'un premier type de conductivité, par exemple de type N. La couche 18 est, par exemple, en un composé III-V, notamment un composé III-N. Des exemples de composés III-N sont GaN, AlN, InN, InGaN, AlGaN ou AlInGaN. L'épaisseur de la couche 18 peut être comprise entre 500 nm et 50 µm, de préférence entre 1 µm et 6 µm.

Chaque diode électroluminescente 16 comprend un empilement de portions de couches semiconductrices comportant, du bas vers le haut en figure 1 :
une portion semiconductrice 24 dopée du premier type de conductivité, par exemple dopée de type N, au contact de la face 20 de la couche 18 ;
une zone active 26 ; et
une portion semiconductrice 28 dopée d'un deuxième type de conductivité opposé au premier type de conductivité, par exemple dopée de type P.

Selon un autre mode de réalisation, la couche semiconductrice 18 peut ne pas être présente.

Selon un mode de réalisation, la zone active 26 et les portions semiconductrices 24 et 28 comprennent chacune majoritairement au moins un composé III-V, notamment un composé III-N. Des exemples de composés III-N sont GaN, AlN, InN, InGaN, AlGaN ou AlInGaN. D'autres éléments du groupe V peuvent également être utilisés, par exemple, le phosphore ou l'arsenic. De façon générale, les éléments dans le composé III-V peuvent être combinés avec différentes fractions molaires. La zone active 26 et les portions semiconductrices 24 et 28 peuvent comprendre chacune un dopant.

La zone active 26 peut comprendre un puits quantique unique. Elle peut alors comprendre un matériau semiconducteur différent du matériau semiconducteur formant les portions semiconductrices 24 et 28 et ayant une bande interdite inférieure à celle des portions semiconductrices 24 et 28. La zone active 26 peut comprendre des puits quantiques multiples. Elle comprend alors un empilement de couches semiconductrices formant une alternance de puits quantiques et de couches barrières.

L'épaisseur de la portion semiconductrice 24 peut être comprise entre 0,1 µm et 20 µm. L'épaisseur de la portion semiconductrice 28 peut être comprise entre 50 nm et 20 µm. L'épaisseur de la zone active 26 peut être comprise entre 10 nm et 500 nm. La largeur D1 de chaque diode électroluminescente 16 est inférieure à 30 µm, de préférence de 5 µm à 30 µm.

Pour chaque diode électroluminescente 16, une portion conductrice électriquement 30 recouvre la portion semiconductrice 28. Les portions conductrices 30 sont par exemple en aluminium ou en argent. L'épaisseur de chaque portion conductrice 30 est, par exemple, entre 3 nm et 400 nm. Des éléments de connexion 32, formés dans un empilement de couches isolantes, relient électriquement la portion conductrice 30 à la puce de commande 14. Des portions conductrices 34 de la puce de commande 14 au contact des éléments de connexion 32 sont représentées en figure 1.

Pour chaque diode électroluminescente 16, les flancs latéraux de la portion semiconductrice 28, de la zone active 26 et au moins d'une partie de la portion semiconductrice 24 sont recouverts d'une portion isolante 36. L'épaisseur de chaque portion isolante 36 peut être choisie telle que ces portions 36 présentent un courant de fuite acceptable sur chacune des diodes électroluminescentes 16.

Des blocs conducteurs électriquement 38 sont prévus entre les diodes électroluminescentes 16. Les blocs 38 sont isolés électriquement des portions semiconductrices 28 et des zones actives 26 des diodes électroluminescentes par les portions isolantes 36. Les blocs conducteurs 38 sont au contact de la face 20 de la couche 18. Les blocs 38 peuvent, en outre, être au contact d'une partie des portions semiconductrices 24. Des éléments de connexion, similaires aux éléments de connexion 32 et 34 et non représentés, relient électriquement les blocs conducteurs 38 à la puce de commande 14.

La puce optoélectronique 12 comprend des blocs photoluminescents 40 sur la face 22 de la couche 18 en vis-à-vis d'au moins certaines diodes électroluminescentes 16. La largeur D2 de chaque bloc photoluminescent 40 peut être sensiblement la même que la largeur D1 de chaque diode électroluminescente 16, c'est-à-dire inférieure à 30 µm, de préférence de 5 µm à 30 µm. L'épaisseur E de chaque bloc photoluminescent 40 est inférieure à 50 µm, de préférence inférieure à 30 µm, plus préférentiellement inférieure à 5 µm, encore plus préférentiellement comprise entre 0,1 µm et 5 µm, par exemple d'environ 1 µm.

Chaque bloc photoluminescent 40 comprend une matrice dans laquelle sont dispersées des particules monocristallines de taille nanométrique d'un matériau semiconducteur, également appelées nanocristaux semiconducteurs par la suite. Le rendement quantique interne QYᵢₙₜ d'un matériau photoluminescent est égal au rapport entre le nombre de photons émis et le nombre de photons absorbés par la substance photoluminescente. Le rendement quantique interne QYᵢₙₜ des nanocristaux semiconducteurs est supérieur à 5 %, de préférence supérieur à 10 %, plus préférentiellement supérieur à 20 %.

Selon un mode de réalisation, la taille moyenne des nanocristaux est comprise entre 0,5 nm et 1000 nm, de préférence entre 0,5 nm et 500 nm, encore plus préférentiellement entre 1 nm et 100 nm, notamment entre 2 nm et 30 nm. Pour des dimensions inférieures à 50 nm, les propriétés de photoconversion des nanocristaux semiconducteurs dépendent essentiellement de phénomènes de confinement quantique. Les nanocristaux semiconducteurs correspondent alors à des boîtes quantiques.

Selon un mode de réalisation, le matériau semiconducteur des nanocristaux semiconducteurs est choisi parmi le groupe comprenant le séléniure de cadmium (CdSe), le phosphure d'indium (InP), le sulfure de cadmium (CdS), le sulfure de zinc (ZnS), le séléniure de zinc (ZnSe), le tellurure de cadmium (CdTe), le tellurure de zinc (ZnTe), l'oxyde de cadmium (CdO), l'oxyde de zinc et de cadmium (ZnCdO), le sulfure de zinc et de cadmium (CdZnS), le séléniure de zinc et de cadmium (CdZnSe), le sulfure d'argent et d'indium (AgInS₂) et un mélange d'au moins deux de ces composés. Selon un mode de réalisation, le matériau semiconducteur des nanocristaux semiconducteurs est choisi parmi les matériaux cités dans la publication au nom de Le Blevennec et al. de Physica Status Solidi (RRL) - Rapid Research Letters Volume 8, No. 4, pages 349-352, avril 2014.

Selon un mode de réalisation, les dimensions des nanocristaux semiconducteurs sont choisies selon la longueur d'onde recherchée du rayonnement émis par les nanocristaux semiconducteurs. A titre d'exemple, des nanocristaux de CdSe dont la taille moyenne est de l'ordre de 3,6 nm sont adaptés à convertir de la lumière bleue en lumière rouge et des nanocristaux de CdSe dont la taille moyenne est de l'ordre de 1,3 nm sont adaptés à convertir de la lumière bleue en lumière verte. Selon un autre mode de réalisation, la composition des nanocristaux semiconducteurs est choisie selon la longueur d'onde recherchée du rayonnement émis par les nanocristaux semiconducteurs.

La matrice est en un matériau au moins en partie transparent. La matrice est, par exemple, en silice. La matrice est, par exemple, en n'importe quel matériau plastique au moins en partie transparent, notamment en un polymère au moins en partie transparent, notamment en silicone ou en acide polyacétique (PLA). La matrice peut être en un polymère au moins en partie transparent utilisé avec les imprimantes tridimensionnelles, tels que le PLA.

Selon un mode de réalisation, la matrice contient de 2 % à 90 %, de préférence de 10 % à 60 %, en masse de nanocristaux, par exemple environ 20 % en masse de nanocristaux.

Le milieu comprenant la matrice et les nanocristaux semiconducteurs a un coefficient d'absorption supérieur à 10³ cm⁻¹.

Les nanocristaux semiconducteurs sont des matériaux à bande interdite directe tandis que les matériaux photoluminescents classiques, tels que le YAG:Ce³⁺, sont des matériaux à bande interdite indirecte. De ce fait, bien que le rendement quantique interne de nanocristaux semiconducteurs soit inférieur au rendement quantique interne des matériaux photoluminescents classiques, tels que le YAG:Ce³⁺, l'épaisseur des blocs photoluminescents 40 peut être inférieure à 30 µm, et de préférence inférieure à 5 µm, car la durée de conversion est plus courte. L'épaisseur des blocs photoluminescents 40 dépend de la concentration des nanocristaux et du type de nanocristaux utilisé.

La figure 2 représente un mode de réalisation d'un dispositif optoélectronique 50 selon l'invention, comprenant l'ensemble des éléments du dispositif optoélectronique 10 et comprenant, en outre, une grille 52 reposant sur la face 22 de la couche 18. La grille 52 comprend un réseau de murs 54 qui délimitent des ouvertures 56, chaque ouverture 56 étant située en vis-à-vis d'une diode électroluminescente 16. Les blocs photoluminescents 40 sont disposés dans certaines des ouvertures 56. La grille 52 peut être réalisée en un matériau isolant, semiconducteur ou conducteur. A titre d'exemple, la grille 52 est en silicium.

Selon un mode de réalisation, les parois latérales des murs 54 sont recouvertes d'un revêtement 58 adapté à réfléchir le rayonnement émis par les blocs photoluminescents 40. Le revêtement 58 est, par exemple, un film d'aluminium ayant une épaisseur comprise entre 10 nm et 2 µm. Ceci permet, de façon avantageuse, d'améliorer le contraste du dispositif d'affichage en empêchant que le rayonnement émis par une diode électroluminescente n'atteigne le bloc photoluminescent associé à une diode électroluminescente adjacente.

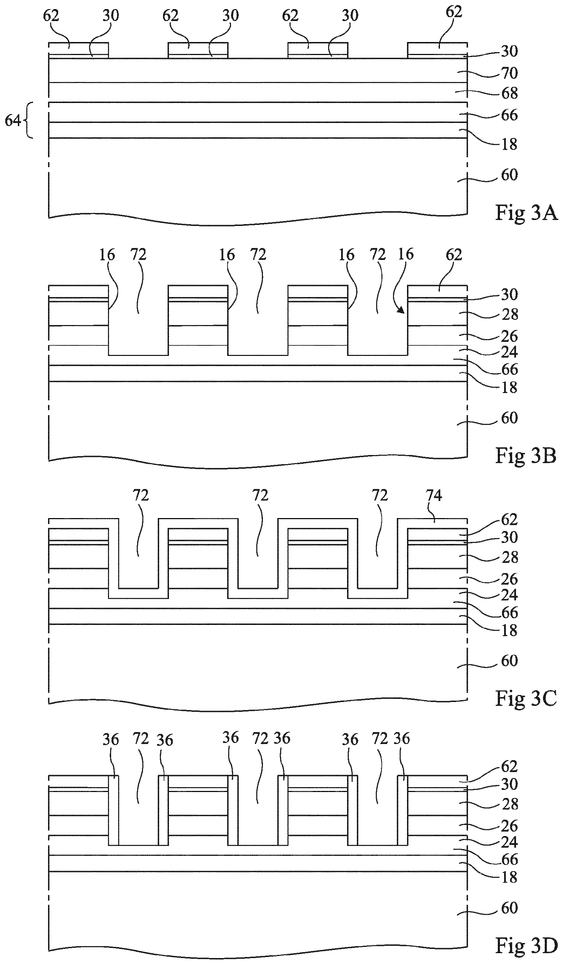

Les figures 3A à 3J illustrent un mode de réalisation d'un procédé de fabrication du dispositif optoélectronique 10 représenté en figure 1, dispositif dont les éléments peuvent être intégrés dans le dispositif 50 selon l'invention représenté en figure 2, dans lequel le procédé de formation des diodes électroluminescentes correspond à celui décrit dans la demande de brevet FR14/50077.

La figure 3A représente la structure obtenue après avoir formé sur un substrat 60, un empilement de couches semiconductrices à partir duquel les diodes électroluminescentes 16 vont être réalisées, les portions conductrices 30 sur l'empilement et des portions diélectriques 62 sur les portions conductrices 30. Le substrat 60 peut correspondre à une structure monobloc ou correspondre à une couche recouvrant un support constitué d'un autre matériau, par exemple du verre ou du métal. Le substrat est, par exemple, un substrat semiconducteur, tel qu'un substrat en silicium, en germanium, en carbure de silicium, en un composé III-V, tel que du GaN ou du GaAs, en un composé II-VI, tel que du ZnO. De préférence, le substrat est en silicium, notamment en silicium monocristallin ou polycristallin. Le substrat 60 est, par exemple, un substrat isolant, par exemple un substrat en saphir.

L'empilement comporte, du bas vers le haut en figure 3A :
une couche semiconductrice 64 dopée de type N, par exemple à base de GaN, qui comporte une première partie plus fortement dopée formant la couche semiconductrice 18, recouvrant le substrat 60, et recouverte d'une partie moins fortement dopée formant une couche semiconductrice 66 dopée N-. A titre de variante, les deux couches 18 et 66 peuvent correspondre à deux couches de matériaux différents, avec par exemple la couche 18 qui peut être à base de GaN et la couche 66 qui peut être à base d'InGaN. En outre, que les deux couches 18 et 66 correspondent à deux couches de matériaux différents ou à une seule couche d'un même matériau, les niveaux de dopage des deux couches 18 et 66 peuvent être similaires ou non ;
des couches actives 68 correspondant à un empilement alterné d'une ou plusieurs couches émissives à puits quantique, par exemple à base d'InGaN, et de couches barrières, par exemple à base de GaN ;
une couche semiconductrice 70, par exemple du GaN, dopée de type P.

Les portions conductrices 30 sont, par exemple, réalisées par un dépôt d'une couche de matériau électriquement conducteur, par exemple de l'aluminium ou de l'argent, suivi d'une lithographie et d'une gravure.

Les portions conductrices 30 et les portions diélectriques 62 ont chacune une forme et des dimensions, dans le plan de la face supérieure de la couche semiconductrice 70 sur laquelle elles sont réalisées, sensiblement similaires à celles souhaitées pour les diodes électroluminescentes 16, et par exemple une section en forme de disque.

La figure 3B représente la structure obtenue après avoir gravé la couche semiconductrice 70, les couches actives 68, et une première partie de la couche semiconductrice 66 selon le motif défini par les portions diélectriques 62, formant, pour chaque diode électroluminescente 16, une structure mesa, par exemple de forme cylindrique, comprenant la zone active 26 disposée entre les portions semiconductrices 24 et 28. Cette gravure est stoppée à un niveau de profondeur situé dans la couche semiconductrice 66 tel qu'une portion de la couche 66 est conservée au fond de chacune des zones gravées de l'empilement.

L'étape de gravure forme, entre les diodes électroluminescentes 16, des espaces vides 72 qui servent par la suite à la réalisation d'une cathode commune aux diodes électroluminescentes 16. La gravure mise en oeuvre est une gravure sèche, par exemple via un plasma à base de Cl₂ ou une gravure ionique réactive (RIE).

La figure 3C représente la structure obtenue après avoir déposé de façon conforme une couche diélectrique 74, par exemple à base de SiN, par exemple comprise entre environ 3 nm et 100 nm, sur les portions diélectriques 62 et le long des parois des espaces vides 72, et recouvrant donc notamment les parois latérales des portions conductrices 30, des portions semiconductrices 28, des zones actives 26 et d'une partie des portions semiconductrices 24.

La figure 3D représente la structure obtenue après avoir réalisé une gravure anisotrope, par exemple une gravure sèche, de façon à retirer les parties de la couche diélectrique 74 se trouvant au fond des espaces vides 72 et sur les portions diélectriques 62. Les portions diélectriques 36 sont ainsi obtenues.

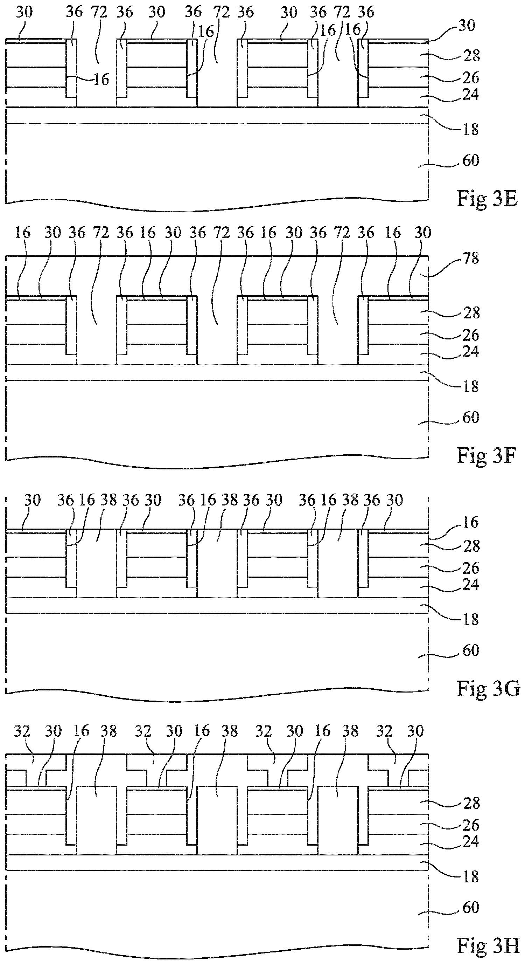

La figure 3E représente la structure obtenue après avoir gravé le reste de la couche semiconductrice 66 au fond des espaces vides 72 jusqu'à la couche semiconductrice 18, après avoir gravé les portions diélectriques 62.

La figure 3F représente la structure obtenue après avoir déposé un matériau électriquement conducteur 78 qui remplit les espaces vides 72 et recouvre les diodes électroluminescentes 16. A titre d'exemple, le matériau conducteur 78 est formé par le dépôt d'une première couche de titane d'épaisseur par exemple égale à environ 10 nm, suivi d'un dépôt d'une deuxième couche d'aluminium d'épaisseur par exemple égale à environ 1 µm.

La figure 3G représente la structure obtenue après avoir réalisé une étape de planarisation, telle qu'une planarisation mécano-chimique (CMP), et/ou une étape de gravure, telle qu'une gravure RIE, du matériau électriquement conducteur 78 jusqu'à atteindre les faces supérieures des portions conductrices 30 et des portions diélectriques 36. Les portions restantes du matériau conducteur 78 disposées entre les diodes électroluminescentes 16 correspondent aux blocs conducteurs 38.

La figure 3H représente la structure obtenue après avoir formé les éléments de connexion 32 au contact des portions conductrices 30 et des blocs conducteurs 38.

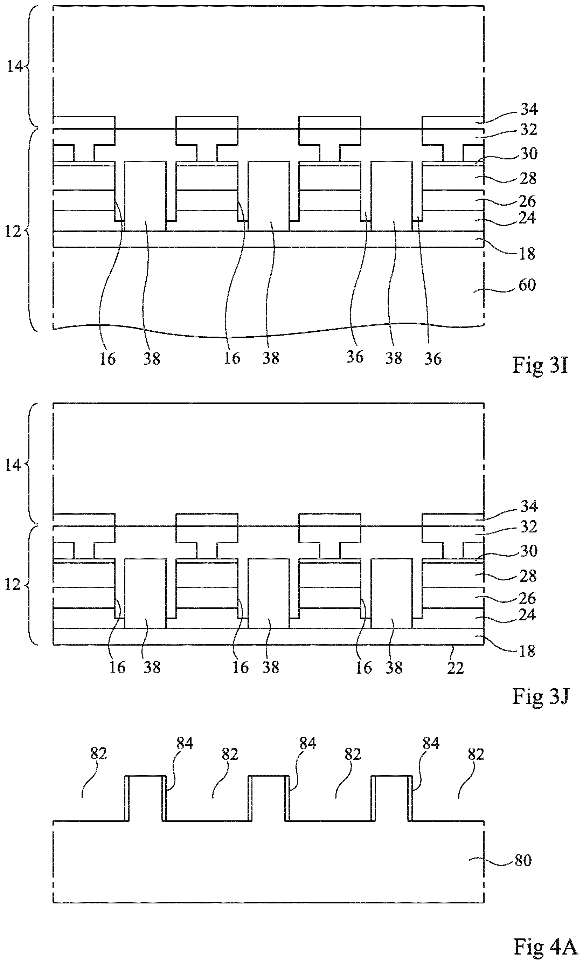

La figure 3I représente la structure obtenue après avoir fixé la puce de commande 14 à la puce optoélectronique 12 du côté des éléments de connexion 32. La fixation de la puce de commande 14 à la puce optoélectronique 12 peut être réalisée par collage direct, sans utilisation d'inserts tels que des microbilles de connexion. Le collage direct peut comprendre un collage direct métal-métal des zones métalliques 32 de la puce optoélectronique 12 et des zones métalliques 34 de la puce de commande 14 et un collage diélectrique-diélectrique des zones diélectriques en surface de la puce optoélectronique 12 et des zones diélectriques en surface de la puce de commande 14. La fixation de la puce de commande 14 à la puce optoélectronique 12 peut être réalisée par un procédé de thermocompression dans lequel la puce optoélectronique 12 est mise en appui contre la puce de commande 14 avec application d'une pression et avec chauffage.

La figure 3J représente la structure obtenue après avoir retiré le substrat 60 de façon à exposer la face 22 de la couche semiconductrice 18. Lorsque le substrat est en un matériau semiconducteur, le substrat 60 peut être retiré par une étape de planarisation, telle qu'une planarisation mécano-chimique (CMP), et/ou une étape de gravure, telle qu'une gravure RIE. Lorsque le substrat 60 est en un matériau isolant comme le saphir, le substrat 60 peut être retiré par ablation laser.

Les étapes suivantes du procédé de fabrication comprennent les étapes de formation des blocs de nanocristaux semiconducteurs 40 sur la face 22 de la couche semiconductrice 12 de façon à obtenir la structure du dispositif optoélectronique 10 telle que représentée en figure 1, structure ne définissant pas, à elle seule, la présente invention. Ceci peut comprendre la réalisation d'une dispersion colloïdale des nanocristaux semiconducteurs dans une matrice liante, la formation de blocs 40 de la dispersion colloïdale sur la face 22 de la couche semiconductrice 18 et le séchage des blocs 40.

Le procédé de formation des blocs 40 peut correspondre à un procédé dit additif, par exemple par impression directe de la dispersion colloïdale aux emplacements souhaités, par exemple par impression par jet d'encre, héliographie, sérigraphie, flexographie, revêtement par pulvérisation (en anglais spray coating) ou dépôt de gouttes (en anglais drop-casting).

Selon un mode de réalisation, les blocs photoluminescents 40 sont réalisés par impression tridimensionnelle. Les dimensions souhaitées des blocs de nanocristaux semiconducteurs 40 sont compatibles avec la résolution des imprimantes tridimensionnelles actuellement disponibles dans le commerce. L'impression tridimensionnelle peut être réalisée en utilisant des buses d'injection piézoélectriques. A titre d'exemple, les trous des buses d'injection peuvent être disposés en quinconce. La dispersion colloïdale peut être chauffée pour pouvoir être injectée à la viscosité souhaitée par les buses d'injection. La puce optoélectronique 12 peut, en outre, être chauffée lors de l'étape d'impression. La matrice de la dispersion colloïdale peut être une résine que l'on fait polymériser après que la dispersion colloïdale a été déposée par impression. A titre d'exemple, la polymérisation de la matrice peut être obtenue en exposant les blocs photoluminescents 40 à un rayonnement électromagnétique, notamment un rayonnement ultraviolet.

Le procédé de formation des blocs 40 peut correspondre à un procédé dit soustractif, dans lequel la dispersion colloïdale est déposée sur la totalité de la face 22 de la couche 18 et dans lequel les portions non utilisées sont ensuite retirées, par exemple par photolithographie ou ablation laser. Selon le matériau considéré, le dépôt sur la totalité de la structure peut être réalisé par dépôt à la tournette, revêtement par pulvérisation, héliographie, revêtement par filière (en anglais slot-die coating), revêtement à la lame (en anglais blade-coating), flexographie ou sérigraphie.

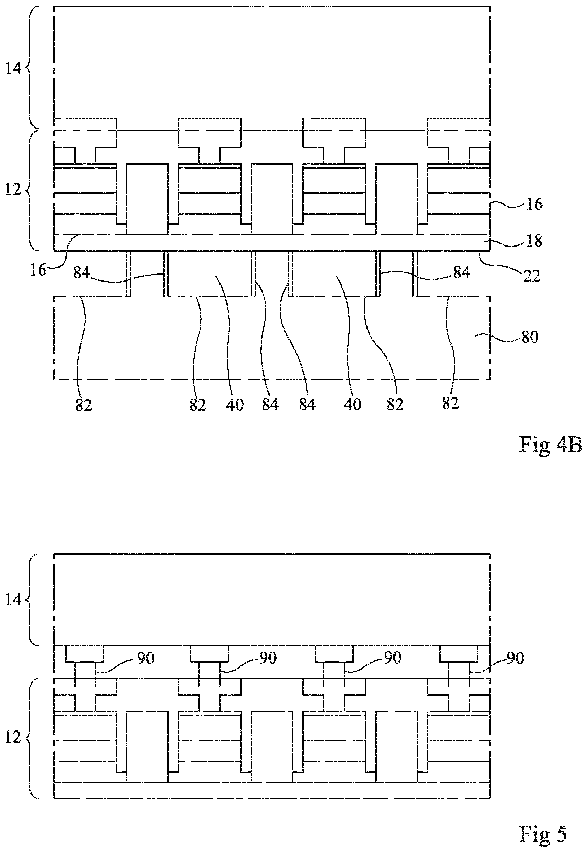

Les figures 4A et 4B représentent les structures obtenues à des étapes d'un mode de réalisation d'un procédé de fabrication selon la présente invention du dispositif optoélectronique 50 représenté en figure 2.

Les étapes initiales du procédé sont celles qui ont été décrites précédemment en relation avec les figures 3A à 3J.

La figure 4A représente la structure obtenue après avoir gravé, dans un substrat 80, des ouvertures 82 non traversantes qui sont destinées à être placées en vis-à-vis des diodes électroluminescentes 16 et après avoir recouvert les parois latérales des ouvertures 82 avec un revêtement réfléchissant 84, par exemple un film d'aluminium. Les dimensions des ouvertures 82 correspondent aux dimensions souhaitées des blocs 40 de nanocristaux semiconducteurs. Les revêtements réfléchissants 84 peuvent être formés par le dépôt d'une couche métallique sur la totalité du substrat 80 et une gravure anisotrope de la couche métallique pour ne conserver le revêtement métallique 84 que sur les parois latérales des ouvertures 82.

La figure 4B représente la structure obtenue après avoir formé les blocs 40 de nanocristaux semiconducteurs dans au moins certaines des ouvertures 82 et après avoir fixé le substrat 80 à la puce optoélectronique 12. Les blocs photoluminescents 40 peuvent être formés en remplissant certaines ouvertures 82 avec la dispersion colloïdale des nanocristaux semiconducteurs, par exemple par un procédé dit additif, éventuellement en obstruant certaines ouvertures 82 avec de la résine. La fixation du substrat 80 à la puce optoélectronique 12 peut être réalisée par collage direct ou par thermocompression.

Les étapes suivantes du mode de réalisation du procédé de fabrication selon la présente invention du dispositif optoélectronique 50 comprennent l'amincissement du substrat 80, depuis le coté du substrat 90 opposé aux diodes électroluminescentes 16 jusqu'à exposer les blocs 40 de nanocristaux semiconducteurs. L'amincissement peut être réalisé par planarisation mécanique et chimique. La structure à grille 52, résultant du substrat 80 aminci, représentée en figure 2 est alors obtenue.

La figure 5 représente la structure obtenue à une étape d'un autre mode de réalisation du procédé de fabrication du dispositif optoélectronique 10, illustratif, ou 50, d'après l'invention, dans lequel l'étape de fixation de la puce optoélectronique 12 à la puce de commande 14 met en oeuvre des inserts 90 entre les deux puces 12 et 14. A titre d'exemple, les inserts 90 peuvent comprendre des nanotubes de carbone.

Des modes de réalisation particuliers ont été décrits. Diverses variantes et modifications apparaîtront à l'homme de l'art. En particulier, bien que dans les modes de réalisation décrits précédemment, la puce optoélectronique 12 soit fixée directement à la puce de commande 14, la puce optoélectronique 12 et la puce de commande 14 peuvent être fixées chacune à un circuit imprimé. L'étendue de la protection conférée est déterminée par les revendications 1 à 11 qui suivent.

## Revendications

1. Procédé de fabrication d'un dispositif optoélectronique (50) comprenant les étapes suivantes :
(a) formation d'une matrice de diodes électroluminescentes (16), chaque diode électroluminescente ayant une dimension latérale (D1) inférieure à 30 µm ; et
(b) formation de blocs photoluminescents (40) en vis-à-vis d'au moins une partie des diodes électroluminescentes, chaque bloc photoluminescent comprenant des cristaux semiconducteurs, dont la taille moyenne est inférieure à 1 µm, dispersés dans une matrice liante,
dans lequel l'étape (a) comprend la fabrication d'un circuit optoélectronique (12) comprenant les diodes électroluminescentes (16) et dans lequel l'étape (b) comprend la formation d'ouvertures (82) non traversantes dans un substrat (80), la formation des blocs photoluminescents (40) dans certaines des ouvertures, la fixation du substrat au circuit optoélectronique et l'amincissement du substrat pour exposer les blocs photoluminescents.

2. Procédé selon la revendication 1, dans lequel chaque bloc photoluminescent (40) a une épaisseur (E) inférieure à 30 µm, de préférence inférieure à 5 µm.

3. Procédé selon la revendication 1 ou 2, dans lequel l'étape (b) comprend la formation des blocs photoluminescents (40) par un procédé additif dans lesdites certaines des ouvertures (82).

4. Dispositif optoélectronique (50) comprenant une matrice de diodes électroluminescentes (16) et des blocs photoluminescents (40) en vis-à-vis d'au moins une partie des diodes électroluminescentes, chaque diode électroluminescente ayant une dimension latérale (D1) inférieure à 30 µm, chaque bloc photoluminescent comprenant des cristaux semiconducteurs, dont la taille moyenne est inférieure à 1 µm, dispersés dans une matrice liante, le dispositif optoélectronique comprenant, en outre, un circuit électronique (12) comprenant les diodes électroluminescentes, et un substrat (80) fixé au circuit électronique (12), les blocs photoluminescents étant localisés dans des ouvertures (82) du substrat, le substrat étant aminci pour exposer les blocs photoluminescents.

5. Dispositif optoélectronique selon la revendication 4, dans lequel chaque bloc photoluminescent (40) a une épaisseur (E) inférieure à 50 µm, de préférence inférieure à 5 µm.

6. Dispositif optoélectronique selon la revendication 4 ou 5, dans lequel la taille moyenne des cristaux semiconducteurs est inférieure à 500 nm, de préférence inférieure à 50 nm.

7. Dispositif optoélectronique selon l'une quelconque des revendications 4 à 6, dans lequel les cristaux semiconducteurs sont au moins en un matériau choisi dans le groupe comprenant le séléniure de cadmium (CdSe), le phosphure d'indium (InP), le sulfure de cadmium (CdS), le sulfure de zinc (ZnS), le séléniure de zinc (ZnSe), le tellurure de cadmium (CdTe), le tellurure de zinc (ZnTe), l'oxyde de cadmium (CdO), l'oxyde de zinc et de cadmium (ZnCdO), le sulfure de zinc et de cadmium (CdZnS), le séléniure de zinc et de cadmium (CdZnSe), le sulfure d'argent et d'indium (AgInS₂), et un mélange d'au moins deux de ces composés.

8. Dispositif optoélectronique selon l'une quelconque des revendications 4 à 7, dans lequel la matrice liante est en un polymère au moins en partie transparent.

9. Dispositif optoélectronique selon l'une quelconque des revendications 4 à 8, dans lequel chaque diode électroluminescente (16) comprend un empilement de portions semiconductrices (24, 26, 28).

10. Dispositif optoélectronique selon l'une quelconque des revendications 4 à 9, dans lequel chaque bloc photoluminescent (40) est entouré latéralement par un revêtement réfléchissant (58, 84).

11. Dispositif optoélectronique selon l'une quelconque des revendications 4 à 10, comprenant un circuit électronique (14) supplémentaire fixé au circuit électronique comprenant les diodes électroluminescentes (16) par collage direct et relié électriquement aux diodes électroluminescentes.

## Patentansprüche

1. Verfahren zur Herstellung einer optoelektronischen Vorrichtung (10; 50), das die folgenden Schritte aufweist:
(a) Bilden einer Anordnung von Leuchtdioden (16), wobei jede Leuchtdiode eine laterale Abmessung (D1) aufweist, die geringer als 30 µm ist; und
(b) Bilden von Photolumineszenzblöcken (40) gegenüberliegend von zumindest einem Teil der Leuchtdioden, wobei jeder Photolumineszenzblock Halbleiterkristalle mit einer durchschnittlichen Größe von weniger als 1 µm aufweist, die in einer Bindematrix dispergiert sind,
wobei Schritt (a) die Herstellung einer optoelektronischen Schaltung (12) aufweist, die die Leuchtdioden (16) aufweist und wobei Schritt (b) das Bilden von nicht durchgehenden Öffnungen (82) in einem Substrat (80), das Bilden der Photolumineszenzblöcke (40) in einigen der Öffnungen, das Bonden des Substrats an die optoelektronische Schaltung und das dünner Machen des Substrats, um die Photolumineszenzblöcke freizulegen, aufweist.

2. Verfahren gemäß Anspruch 1, wobei jeder Photolumineszenzblock (40) eine Dicke (E) von weniger als 30 µm aufweist, und vorzugsweise von weniger als 5 µm.

3. Verfahren gemäß Anspruch 1 oder 2, wobei der Schritt (b) das Bilden der Photolumineszenzblöcke (40) durch einen Hinzufügungsprozess in den einzelnen Öffnungen (82) aufweist.

4. Optoelektronische Vorrichtung (50), die eine Anordnung von Leuchtdioden (16) und Photolumineszenzblöcken (40) gegenüberliegend von zumindest einem Teil der Leuchtdioden aufweist, wobei jede Leuchtdiode eine laterale Abmessung (D1) von weniger als 30 µm aufweist, wobei jeder Photolumineszenzblock Halbleiterkristalle aufweist, die eine durchschnittliche Größe von weniger als 1 µm aufweisen, die in einer Bindematrix dispergiert sind, wobei die optoelektronische Vorrichtung ferner eine elektronische Schaltung (12) aufweist, die Leuchtdioden aufweist, sowie ein Substrat (80), das an die elektronische Schaltung (12) gebondet ist, wobei die Photolumineszenzblöcke in den Öffnungen (82) des Substrats gelegen sind, wobei das Substrat dünner gemacht ist, um die Photolumineszenzblöcke freizulegen.

5. Optoelektronische Vorrichtung gemäß Anspruch 4, wobei jeder Photolumineszenzblock (40) eine Dicke (E) aufweist, die kleiner als 50 µm ist und vorzugsweise kleiner als 5 µm ist.

6. Optoelektronische Vorrichtung gemäß Anspruch 4 oder 5, wobei die durchschnittliche Größe der Halbleiterkristalle kleiner als 500 nm ist und vorzugsweise kleiner als 50 nm ist.

7. Optoelektronische Vorrichtung gemäß einem der Ansprüche 4 bis 6, wobei die Halbleiterkristalle aus mindestens einem der Materialien bestehen, die aus der Gruppe ausgewählt werden, die Folgendes aufweist: Cadmiumselenid (CdSe), Indiumphosphid (InP), Cadmiumsulfid (CdS), Zinksulfid (ZnS), Zinkselenid (ZnSe), Cadmiumtellurid (CdTe), Zinktellurid (ZnTe), Cadmiumoxid (CdO), Cadmiumzinkoxid (ZnCdO), Cadmiumzinksulfid (CdZnS), Zinkcadmiumselenid (CdZnSe), Silberindiumsulfid (AgInS₂) und eine Mischung von zumindest zwei dieser Komponenten.

8. Optoelektronische Vorrichtung gemäß einem der Ansprüche 4 bis 7, wobei die Bindematrix aus einem zumindest teilweise transparenten Polymer besteht.

9. Optoelektronische Vorrichtung gemäß einem der Ansprüche 4 bis 8, wobei jede Leuchtdiode (16) einen Stack bzw. Stapel von Halbleiterteilen (24, 26, 28) aufweist.

10. Optoelektronische Vorrichtung gemäß einem der Ansprüche 4 bis 9, wobei jeder Photolumineszenzblock (40) lateral von einer reflektierenden Wand (58, 84) umgeben ist.

11. Optoelektronische Vorrichtung gemäß einem der Ansprüche 4 bis 10, die eine zusätzliche elektronische Schaltung (14) aufweist, die an die elektronische Schaltung, die die Leuchtdioden (16) aufweist, durch direktes Bonden gebondet ist und mit den Leuchtdioden elektrisch verbunden ist.

## Claims

1. A method of manufacturing an optoelectronic device (10; 50), comprising the steps of:
(a) forming an array of light-emitting diodes (16), each light-emitting diode having a lateral dimension (D1) smaller than 30 µm; and
(b) forming photoluminescent blocks (40) opposite at least part of the light-emitting diodes, each photoluminescent block comprising semiconductor crystals having an average size smaller than 1 µm, dispersed in a binding matrix,
wherein step (a) comprises manufacturing an optoelectronic circuit (12) comprising the light-emitting diodes (16) and wherein step (b) comprises forming non-through openings (82) in a substrate (80), forming the photoluminescent blocks (40) in some of the openings, bonding the substrate to the optoelectronic circuit and thinning the substrate to expose the photoluminescent blocks.

2. The method of claim 1, wherein each photoluminescent block (40) has a thickness (E) smaller than 30 µm, preferably smaller than 5 µm.

3. The method of claim 1 or 2, wherein step (b) comprises forming the photoluminescent blocks (40) by an additive process in said some of the openings (82).

4. An optoelectronic device (50) comprising an array of light-emitting diodes (16) and photoluminescent blocks (40) opposite at least a portion of the light-emitting diodes, each light-emitting diode having a lateral dimension (D1) smaller than 30 µm, each photoluminescent block comprising semiconductor crystals, having an average size smaller than 1 µm, dispersed in a binding matrix, the optoelectronic device further comprising an electronic circuit (12) comprising the light-emitting diodes, and a substrate (80) bonded to the electronic circuit (12), the photoluminescent blocks being located in openings (82) of the substrate, the substrate being thinned to expose the photoluminescent blocks.

5. The optoelectronic device of claim 4, wherein each photoluminescent block (40) has a thickness (E) smaller than 50 µm, preferably smaller than 5 µm.

6. The optoelectronic device of claim 4 or 5, wherein the average size of the semiconductor crystals is smaller than 500 nm, preferably smaller than 50 nm.

7. The optoelectronic device of any of claims 4 to 6, wherein the semiconductor crystals are made of at least one material selected from the group comprising cadmium selenide (CdSe), indium phosphide (InP), cadmium sulfide (CdS), zinc sulfide (ZnS), zinc selenide (ZnSe), cadmium telluride (CdTe), zinc telluride (ZnTe), cadmium oxide (CdO), cadmium zinc oxide (ZnCdO), cadmium zinc sulfide (CdZnS), zinc cadmium selenide (CdZnSe), silver indium sulfide (AgInS₂), and a mixture of at least two of these compounds.

8. The optoelectronic device of any of claim 4 to 7, wherein the binding matrix is made of an at least partly transparent polymer.

9. The optoelectronic device of any of claims 4 to 8, wherein each light-emitting diode (16) comprises a stack of semiconductor portions (24, 26, 28).

10. The optoelectronic device of any of claims 4 to 9, wherein each photoluminescent block (40) is laterally surrounded with a reflective wall (58, 84).

11. The optoelectronic device of any of claims 4 to 10, comprising an additional electronic circuit (14) bonded to the electronic circuit comprising the light-emitting diodes (16) by direct bonding and electrically connected to the light-emitting diodes.
